# EUROPEAN PATENT APPLICATION

(11) **EP 3 352 223 A1**
(43) Date of publication of application: **25.07.2018**
(21) Application number: 18152192.3
(22) Date of filing: 17.01.2018
(51) Int. Cl.: H01L 27/32

(54) **ELECTRONIC DEVICE, DISPLAY DEVICE AND METHOD FOR MANUFACTURING A DISPLAY DEVICE**

(30) Priority: 24.01.2017 CN 201710055261
(71) Applicant: Beijing Xiaomi Mobile Software Co., Ltd., Beijing 100085 (CN)
(72) Inventor: YU, Tao, Beijing, 100085 (CN); HAN, Gaocai, Beijing, 100085 (CN); LI, Zhuxin, Beijing, 100085 (CN)
(74) Representative: Hughes, Andrea Michelle

(57) **Abstract**

The present disclosure relates to an electronic device, display device and method for manufacturing a display device. The display device includes: a flexible OLED layer (10) having at least one edge (12) comprising a curved section (100) and a first body section (110) and a second body section (120) connected by the curved section (100), wherein the first body section (110) is located adjacent to a front side of the display device, while the second body section (120) is located spaced from the front side of the display device; and a drive chip (20) disposed on the second body section(120).

## Description

### FIELD

The present disclosure generally relates to the technical field of display devices, and more particularly, to an electronic device, display device and method for manufacturing a display device.

### BACKGROUND

Screen-to-body ratio of an electronic device, such as a mobile communication terminal (e.g., a mobile phone), a PDA, a mobile computer, a tablet computer and the like, refers to a relative ratio of a screen area and a front panel area of the electronic device. Greater screen-to-body ratio means a narrower bezel of the electronic device, by which an overall volume of the electronic device may be reduced given a certain screen area, and thereby portability requirements for the electronic device can be satisfied. Thus, bezel-less display is becoming more and more popular among consumers, and is also an inevitable trend for future development of electronic devices such as a mobile phone.

However, an integrated circuit (IC) bonding area is utilized in traditional manufacturing and display technologies for a screen of an electronic device such as a mobile phone, so as to provide an IC drive chip which is an essential element of a screen display function. In legacy solutions, the IC bonding area is placed above or below the display screen, resulting in some non-display area on the front side of the mobile phone, and thus making it difficult to further increase the screen-to-body ratio. Thus, in legacy solutions, the IC bonding area needs to occupy some screen space, and thereby the bezel-less display cannot be realized.

### SUMMARY

An electronic device, display device and method for manufacturing a display device are provided in the present disclosure.

According to a first aspect of embodiments of the present disclosure, a display device is provided. The display device includes: a flexible organic light-emitting diode (OLED) layer having at least one edge including a curved section and a first body section and a second body section connected by the curved section, wherein the first body section is located adjacent to the front side of the display device, while the second body section is located spaced from the front side of the display device; and a drive chip provided on the second body section.

In some exemplary embodiments, the first body section, the curved section and the second section may be integrally formed as one piece.

In some exemplary embodiments, the curved section may have a curved angle that ranges between 150° and 210°.

In some exemplary embodiments, the display device may further include a glass cover covering the first body section and the curved section.

In some exemplary embodiments, the display device may further include a flexible printed circuit board (PCB). The flexible printed circuit board includes a first part and a second part adjacent to each other, wherein the first part penetrates through the first body section, the curved section and the second body section, while the second part protrudes from the second body section.

In some exemplary embodiments, the second body section may include a bonding area, and the drive chip may be disposed in the bonding area.

In some exemplary embodiments, the display device may further include a controller. The controller may be connected with the first body section, the curved section and the second section. The controller may be configured to control turned-on or turned-off of each of the first body section, the curved section and the second body section.

According to a second aspect of embodiments of the present disclosure, an electronic device is provided. The electronic device includes: a housing and a display device as described above, wherein the display device is provided on a front side of the housing.

According to a third aspect of embodiments of the present disclosure, a method for manufacturing a display device is provided. The method includes: providing a flexible OLED layer comprising a curved section and a first body section and a second body section connected by the curved section; placing the first body section adjacent to a front side of the display device, while placing the second body section spaced from the front side of the display device; and providing a drive chip on the second body section.

In some exemplary embodiments, the curved section may have a curved angle that ranges between 150° and 210°.

In some exemplary embodiments, the method may further include: providing a glass cover covering the first body section and the curved section.

In some exemplary embodiments, the method may further include: providing a flexible printed circuit board (PCB) including a first part and a second part adjacent to each other, wherein the first part penetrates through the first body section, the curved section and the second body section, while the second part protrudes from the second body section.

In some exemplary embodiments, providing the drive chip on the second body section may include: preserving a bonding area on the second body section, and placing the drive chip in the bonding area.

In some exemplary embodiments, the curved section and the second body section may be set to be a turned-off state.

The technical solutions provided by embodiments of the present disclosure may attain the following beneficial effects.

It can be seen from the embodiments described above that the display device of the present disclosure utilizes the flexible OLED layer which is curved and then provides the drive chip on the second body section of the flexible OLED layer located more remote from the front side of the display device, such that the drive chip does not occupy any place on the first body section of the flexible OLED layer located adjacent to the front side of the display device, and thereby more display space may be preserved on the front side of the display device to fulfill bezel-less display.

It is to be understood that the forgoing general description and the following detailed description are illustrative and explanatory only, and are not intended to limit the present disclosure.

### BRIEF DESCRIPTION OF THE DRAWINGS

The accompanying drawings, which are incorporated in and constitute a part of this specification, illustrate embodiments consistent with the present disclosure and, together with the description, serve to explain the principles of the present disclosure.
Fig. 1 is a structure diagram of a display device in the related art.
Fig. 2 is a structure diagram illustrating a display device according to an example embodiment of the present disclosure.
Fig. 3 is a stereoscopic diagram illustrating the rear side of a flexible OLED layer of a display device according to an example embodiment of the present disclosure.
Fig. 4 is a flow chart illustrating a method for manufacturing a display device according to an example embodiment of the present disclosure.

### DETAILED DESCRIPTION

Example embodiments will now be described in detail, examples of which are illustrated in the accompanying drawings. The following description refers to the accompanying drawings in which same numbers in different drawings represent same or similar elements unless otherwise described. The implementations set forth in the following description of example embodiments do not represent all implementations consistent with the present disclosure. Instead, they are merely examples of device and methods consistent with aspects related to the present disclosure as recited in the appended claims.

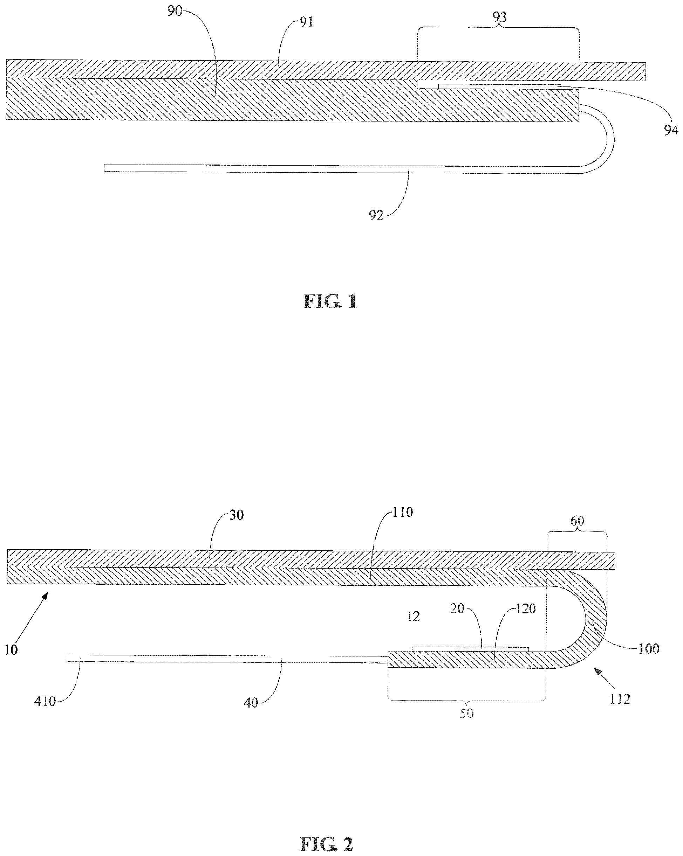

Referring to Fig.1, it is a structure diagram of a display device in the related art. The display device includes a display panel 90, a glass cover 91, and a flexible printed circuit board (PCB) 92. The display panel 90 has an IC bonding area 93 on its front side, and an IC drive chip 94 is provide in the IC bonding area 93. The PCB 92 penetrates through and protrudes partly from the display panel 90. Because the IC bonding area 93 is placed front side or rear side of the display panel 90 (in Fig.1, the IC bonding area 93 is provided at the front side of the display panel 90), it occupies some screen space, and thus there may always be some non-display area on the front side of the display device, which means the screen-to-body ratio cannot be further increased, and thereby the bezel-less display cannot be realized.

In view of the aforementioned disadvantages in the related art, an electronic device, display device and method for manufacturing a display device are provided in the present disclosure to solve the problem that a bezel-less display cannot be realized in display devices in the related art. In the following, the electronic device, display device and method for manufacturing a display device of the present disclosure will be described in detail in connection with the accompanying figures. Where appropriate, features in the following embodiments and implementations may be combined with each other.

Referring to Fig.2, it is a structure diagram illustrating a display device according to an example embodiment of the present disclosure. The display device provided in embodiments of the present disclosure includes: a flexible OLED layer 10 (it serves as a display panel) having at least one edge 12 of which may include a curved section 100, and a first body section 110 and a second body section 120 connected by the curved section 100, wherein the first body section 110 is located adjacent to the front side of the display device (in Fig.2, the upper side of the flexible OLED layer 10 represents the front side of the display device), while the second body section 120 is located spaced from the front side of the display device (in other words, located on a rear side of the display device). The flexible OLED layer is used as the display panel such that it is possible for the display panel to utilize advantages of the OLED display technology, for example, self-luminous, wide viewing angle, almost infinitely high contrast, lower power consumption, and very high reaction speed, etc.

A drive chip 20 is provided on the second body section 120. In some embodiments, the drive chip 20 may be placed on a side of the second body section 120 that is near the front side of the display device, so that the drive chip 20 is located in an area inside the flexible OLED layer 10. Thus, the volume of the display device can be further reduced.

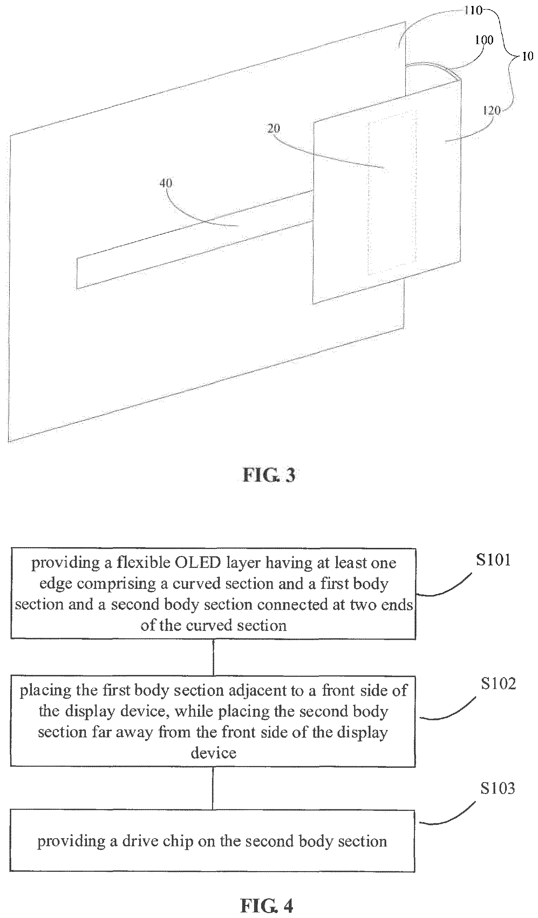

It should be noted that it may be that only a part of an edge 112 of the first body section 110 of the flexible OLED layer 10 is protruded and curved to form the curved section 100, and the second body section 120 has the same width as that of the curved section 100. In some exemplary embodiments, it may be that the edge 112 of the first body section 110 of the flexible OLED layer 10 is entirely protruded and curved to form the curved section 100. Moreover, the edge 112 of the first body section 110 of the flexible OLED layer 10 to be curved may be a long side of the first body section 110, or a short side of the first body section 110. For example, in the example of Fig.3, it is that only a part of an edge 112 of the first body section 110 of the flexible OLED layer 10 is protruded and curved to form the curved section 100, while the second body section 120 has the same width as that of the curved section 100, and the drive chip 20 is provided on the second body section 120. As described above, because the drive chip 20 is located in an area inside the flexible OLED layer 10, the drive chip 20 is invisible in Fig.3.

In some embodiments, the display device of the present disclosure utilizes the flexible OLED layer as the display screen, which is curved to form the first body section, the curved section, and the second body section, and then places the drive chip on the second body section of the flexible OLED layer located spaced from the front side of the display device, such that the drive chip does not occupy any space on the first body section of the flexible OLED layer located adjacent to the front side of the display device, and thereby more space may be preserved on the front side of the display device to fulfill bezel-less display.

In one implementation of the present disclosure, the first body section 110, the curved section 100 and the second body section 120 may be integrally formed as one piece. In some exemplary embodiments, the curved angle of the curved section 100 may range from 150° to 210°, and preferably, the curved angel is 180°.

In one implementation of the present disclosure, the display device may also include a glass cover 30 covering the first body section 110 and the curved section 100 of the flexible OLED layer 10. Light emitted from the flexible OLED layer 10 is displayed after passing through the glass cover 30.

Referring to Fig.2, in one implementation of the present disclosure, the display device may also include a PCB 40. The PCB 40 includes a first part (not shown) and a second part 410 adjacent to each other, wherein the first part penetrates through the first body section 110, the curved section 100 and the second body section 120, while the second part 410 protrudes from the second body section 120. In some exemplary embodiments, the first part and second part 410 of the PCB 40 may be integrally formed. The PCB 40 may be used to provide supports in terms of circuit arrangement for the drive chip 20.

In one implementation of the present disclosure, a bonding area 50 may be provided on the second body section 120 of the flexible OLED layer 10, and the drive chip 20 is placed in the bonding area 50. In some exemplary embodiments, the drive chip 20 may be an integrated circuit (IC) drive chip, and the bonding area 50 may be an IC bonding area.

In one implementation of the present disclosure, the display device may also include a controller connected with the first body section 110, the curved section 100 and the second body section 120, the controller may be configured to control turn-on or turn-off of each of the first body section 110, the curved section 100 and the second body section 120. Although the glass cover 30 covers the curved section 100 of the flexible OLED layer 10, the curved area 60 formed by the curved section 100 is not within a visible area and thus is useless for display of the display screen. Further, if the curved section 100 within the curved area 60 is not turned off to stop emitting light, there may exist some risks such as power consumption, light leakage, etc. Thus, the controller controls the curved section 100 and the second body section 120 of the flexible OLED layer 10 to always be in a turned-off state, so as to avoid risks such as power consumption, light leakage, etc. In some exemplary embodiments, the controller may use a software algorithm control to turn off display function of the curved section 100 and the second body section 120.

Referring to Fig.4, it is a flow chart illustrating a method for manufacturing a display device according to an example embodiment of the present disclosure. In connection with Fig. 2 and Fig.4, a method for manufacturing a display device is also provided in embodiments of the present disclosure. The method may include the following steps.

Step S101: a flexible OLED layer 10 is provided such that it has at least one edge comprising a curved section 100 and a first body section 110 and a second body section 120 connected by the curved section 100.

Step S102: the first body section 110 is placed adjacent to the front side of the display device (in Fig.2, the upper side of the flexible OLED layer 10 represents the front side of the display device), while the second body section 120 is placed spaced from the front side of the display device.

Step S103: a drive chip 20 is provided on the second body section 120. In some embodiments, the drive chip 20 may be placed on a side of the second body section 120 that is near to the front side of the display device, such that the drive chip 20 is located in an area inside the flexible OLED layer 10 to further reduce the volume of the display device.

In the embodiments described above, the method for manufacturing a display device of the present disclosure utilizes the flexible OLED layer as the display screen which is curved to form the first body section, the curved section, and the second body section, and then provides the drive chip on the second body section of the flexible OLED layer located spaced from the front side of the display device, such that the drive chip does not occupy any space on the first body section of the flexible OLED layer located adjacent to the front side of the display device, and thereby more space may be preserved on the front side of the display device to fulfill bezel-less display.

In one implementation of the present disclosure, the curved angle of the flexible OLED layer 10 may ranges from 150° to 210°, and preferably, 180°. That is, the curved angle of the curved section 100 of the flexible OLED layer 10 may range from 150° to 210°, and preferably, the curved angle is 180°.

In one implementation of the present disclosure, the method for manufacturing a display device may also include: providing a glass cover 30 covering the first body section 110 and the curved section 100. Lights emitted from the flexible OLED layer 10 are displayed after passing through the glass cover 30.

Referring to Fig.2, in one implementation of the present disclosure, the method for manufacturing a display device may also include: providing a PCB 40, the PCB 40 includes a first part (not shown) and a second part 410 adjacent to each other, wherein the first part penetrates through the first body section 110, the curved section 100 and the second body section 120, while the second part 410 protrudes from the second body section 120. In some exemplary embodiments, the first part and second part 410 of the PCB 40 may be integrally formed. The PCB 40 may be used to provide supports in terms of circuit arrangement for the drive chip 20.

In one implementation of the present disclosure, the above described step S103 of providing the drive chip 20 on the second body section 120 may further include: preserving a bonding area 50 on the second body section 120, and provide the drive chip 20 in the bonding area 50. In some exemplary embodiments, the drive chip 20 may be an IC drive chip, and the bonding area 50 may be an IC bonding area.

In one implementation of the present disclosure, the curved section 100 and the second body section 120 may be set to be in turned-off state. Although the glass cover 30 covers the curved section 100 of the flexible OLED layer 10, but the curved area 60 formed by the curved section 100 is in an invisible area and thus is useless for the display of the display screen,. Further, when the curved section 100 in the curved area 60 is not turned off to stop emitting light, there may exist some risks such as power consumption, light leakage, etc. Thus, the curved section 100 and the second body section 120 of the curved OLED layer 10 may be set always to be in a turned-off state (i.e., the display function of the curved section 100 and the second body section 120 is turned off), so as to avoid risks such as power consumption, light leakage, etc.

An electronic device is also provided in embodiments of the present disclosure. The electronic device include a housing and a display device according to the aforementioned embodiments and implementations, or a display device manufactured by the method described above, wherein the display device is provided on a front side of the housing. It should be noted that descriptions about the display device in the aforementioned embodiments and implementations are also suitable for the electronic devices provided in embodiments of the present disclosure.

In the electronic device of the present disclosure, the display device utilizes the flexible OLED layer as the display screen which is curved to form the first body section, the curved section, and the second body section. The electronic device further includes a display drive chip on the second body section of the flexible OLED layer located spaced from the front side of the display device, such that the display drive chip dose not occupy any space on the first body section of the flexible OLED layer located adjacent to the front side of the display device. Therefore, more space may be preserved on the front side of the display device to fulfill bezel-less display.

In one implementation of the present disclosure, the electronic device may also include at least one sensor component provided on a rear side of the housing. In some exemplary embodiments, the sensor component may include at least one of a proximity sensor and a light sensor. By providing the sensor component on the rear side of the housing, more spaces on the front side of the housing may be provided to the display device to increase the screen-to-body ratio and beautify appearance of the display device.

Further, the electronic device of the present disclosure may also include a flashlight, an earpiece component, a camera component, and an inductive touch control component (e.g., an inductive touch control component with fingerprint recognition function), all of which may be provided on the rear side of the housing, with only the display device being provided on the front side of the housing to fulfill bezel-less display.

In one implementation of the present disclosure, the electronic device may be a mobile communication terminal (e.g., a mobile phone), a personal digital assistant (PDA), a mobile computer, and a tablet computer.

Other embodiments of the disclosure will be apparent to those skilled in the art from consideration of the specification and practice of the disclosures herein. This disclosure is intended to cover any variations, uses, or adaptations of the disclosure following the general principles thereof and including such departures from the present disclosure as come within known or customary practice in the art. It is intended that the specification and embodiments be considered as illustrative only, with a true scope of the disclosure being indicated by the following claims.

It will be appreciated that the present disclosure is not limited to the exact construction that has been described above and illustrated in the accompanying drawings, and that various modifications and changes can be made without departing from the scope thereof. It is intended that the scope of the invention only be limited by the appended claims.

## Claims

1. A display device, **characterized in that** the display device comprises:
a flexible OLED layer (10) having at least one edge (12) comprising a curved section (100) and a first body section (110) and a second body section (120) connected by the curved section (100), wherein the first body section (110) is located adjacent to a front side of the display device, while the second body section (120) is located spaced from the front side of the display device; and
a drive chip (20) disposed on the second body section (120).

2. The display device of claim 1, wherein the first body section (110), the curved section (100) and the second body section (120) are integrally formed as one piece.

3. The display device of claim 1, where the curved section (100) has a curved angle that ranges between 150° and 210°.

4. The display device of claim 1, further comprising a glass cover (30) covering the first body (110) section and the curved section (100).

5. The display device of claim 1, further comprising a flexible printed circuit board (40) comprising a first part and a second part (410) adjacent to each other, wherein the first part penetrates through the first body section (110), the curved section (100) and the second body section (120), while the second part (410) protrudes from the second body section (120).

6. The display device of claim 1, wherein the second body section (120) comprises a bonding area (50), and the drive chip (20) is disposed in the bonding area (50).

7. The display device of claim 1, further comprising a controller connected with the first body section (110), the curved section (100) and the second body section (120), the controller is configured to control turned-on or turned-off of each of the first body section, the curved section and the second body section.

8. An electronic device, **characterized in that** the electronic device comprises a housing and a display device according to any of claims 1∼7, wherein the display device is provided on a front side of the housing.

9. A method for manufacturing a display device, **characterized in that** the method comprises:
providing a flexible OLED layer (10) having at least one edge (12) comprising a curved section (100) and a first body section (110) and a second body section (120) connected by the curved section (100);
placing the first body section (110) adjacent to a front side of the display device, while placing the second body section (120) spaced from the front side of the display device; and
providing a drive chip (20) on the second body section (120).

10. The method of claim 9, wherein the curved section (100) has a curved angle that ranges between 150° and 210°.

11. The method of claim 9, further comprising: providing a glass cover (30) covering the first body section (110) and the curved section (100).

12. The method of claim 9, further comprising: providing a flexible printed circuit board (40) comprising a first part and a second part (410) adjacent to each other, wherein the first part penetrates through the first body section (110), the curved section (100) and the second body section (120), while the second part (410) protrudes from the second body section (120).

13. The method of claim 9, wherein providing the drive chip (20) on the second body section (120) comprises: preserving a bonding area (50) on the second body section (120), and placing the drive chip (20) in the bonding area (50).

14. The method of claim 9, wherein the curved section (100) and the second body section (120) are set to be in a turned-off state.
